# EUROPEAN PATENT SPECIFICATION

(11) **EP 4 079 711 B1**
(45) Date of publication and mention of the grant of the patent: **11.03.2026**
(21) Application number: 20902360.5
(22) Date of filing: 04.12.2020
(51) Int. Cl.: C04B 37/02, H01L 23/13, H05K 3/38

(54) **COPPER/CERAMIC JOINED BODY AND INSULATED CIRCUIT BOARD**
KUPFER/KERAMIK-VERBUNDKÖRPER UND ISOLIERENDE SCHALTUNGSPLATTE
CORPS ASSEMBLÉ EN CUIVRE/CÉRAMIQUE ET CARTE DE CIRCUIT IMPRIMÉ ISOLÉE

(30) Priority: 19.12.2019 JP 2019228780; 26.11.2020 JP 2020196300
(43) Date of publication of application: 26.10.2022
(73) Proprietor: Mitsubishi Materials Corporation, Tokyo 100-8117 (JP)
(72) Inventor: TERASAKI, Nobuyuki, Saitama-shi, Saitama 330-8508 (JP)
(74) Representative: Hoffmann Eitle
(86) International application number: PCT/JP2020/045199
(87) International publication number: WO 2021/124923

(56) References cited:
- EP-A1- 3 492 441
- EP-A1- 3 632 879
- WO-A1-2017/213207
- WO-A1-2018/021472
- WO-A1-2018/221493
- WO-A1-2018/221493
- JP-A- 2000 183 476
- JP-A- 2005 112 677
- JP-A- 2009 170 930
- JP-A- 2018 008 869
- JP-A- 2018 140 929
- JP-B2- 5 899 725
- US-A1- 2019 150 298

## Description

### TECHNICAL FIELD

The present invention relates to a copper/ceramic bonded body in which a copper member made of copper or a copper alloy and a ceramic member made of silicon-containing ceramics are bonded to each other, and an insulating circuit substrate in which a copper sheet made of copper or a copper alloy is bonded to a surface of a ceramic substrate made of silicon-containing ceramics.

Priority is claimed on Japanese Patent Application No. 2019-228780, filed December 19, 2019, and Japanese Patent Application No. 2020-196300, filed November 26, 2020.

### BACKGROUND ART

A power module, an LED module, and a thermoelectric module have a structure in which a power semiconductor element, an LED element, and a thermoelectric element are bonded to an insulating circuit substrate in which a circuit layer made of a conductive material is formed on one surface of an insulating layer.

For example, a power semiconductor element for high-power control used for controlling a wind power generation, an electric vehicle, a hybrid vehicle, or the like has a large amount of heat generated during operation. Therefore, as a substrate on which the power semiconductor element is mounted, an insulating circuit substrate including a ceramic substrate and a circuit layer formed by bonding a metal plate having excellent conductivity to one surface of the ceramic substrate has been widely used in the related art. As the insulating circuit substrate, one having a metal layer formed by bonding a metal plate to the other surface of the ceramic substrate is also provided.

For example, Patent Document 1 proposes a power module substrate in which a first metal plate and the second metal plate constituting a circuit layer and a metal layer are made of a copper sheet, and the copper sheet is directly bonded to a ceramic substrate by a DBC method. In this DBC method, the copper sheet and the ceramic substrate are bonded to each other by forming a liquid phase at an interface between the copper sheet and the ceramic substrate by using a eutectic reaction of copper with a copper oxide.

In addition, Patent Document 2 proposes an insulating circuit substrate in which a circuit layer and a metal layer are formed by bonding a copper sheet to one surface and the other surface of a ceramic substrate. In Patent Document 1, the copper sheet is disposed on one surface and the other surface of the ceramic substrate with an Ag-Cu-Ti-based brazing material interposed therebetween, and the copper sheet is bonded thereto by performing a heating treatment (so-called active metal brazing method). In the active metal brazing method, since the brazing material containing Ti is used as an active metal, the wettability between the molten brazing material and the ceramic substrate is improved, and the ceramic substrate and the copper sheet are satisfactorily bonded to each other.

Further, Patent Document 3 proposes a power module substrate in which a copper sheet made of copper or a copper alloy and a ceramic substrate made of silicon nitride are bonded to each other using a bonding material containing Ag and Ti, and in which a nitride compound layer and an Ag-Cu eutectic layer are formed at a bonded interface, and a thickness of the nitride compound layer is in a range of 0.15 µm or more and 1.0 µm or less.

Patent Document 4 discloses a ceramic circuit substrate wherein a ceramic substrate and a copper plate are bonded by a braze material containing Ag and Cu, at least one active metal component selected from Ti and Zr, and at least one element selected from among In, Zn, Cd, and Sn.

Patent Document 5 discloses a copper-ceramic joined body comprising a ceramic substrate, a copper plate and a joining layer wherein a nanoindentation hardness of the joining layer is preferred to fall within a range of 1.0 to 2.5 GPa.

### [Citation List]

### [Patent Documents]

[Patent Document 1]
   Japanese Unexamined Patent Application, First Publication No. H04-162756
[Patent Document 2]
   Japanese Patent No. 3211856
[Patent Document 3]
   Japanese Unexamined Patent Application, First Publication No. 2018-008869
[Patent Document 4] WO 2018/221493 A1
[Patent Document 5] EP 3 492 441 A1

### SUMMARY OF INVENTION

### Technical Problem

However, as disclosed in Patent Document 1, when the ceramic substrate and the copper sheet are bonded to each other by the DBC method, the bonding temperature needs to be set to 1065°C or higher (equal to or higher than eutectic point temperature of copper and copper oxide), so that there is a concern that the ceramic substrate deteriorates during bonding.

In addition, as disclosed in Patent Document 2, when the ceramic substrate and the copper sheet are bonded to each other by the active metal brazing method, a bonding temperature is set to a relatively high temperature of at 900°C, so that there is a problem that the ceramic substrate deteriorates.

Here, in Patent Document 3, since the copper sheet made of copper or a copper alloy and the ceramic substrate made of silicon nitride are bonded to each other by using the bonding material containing Ag and Ti, the ceramic member and the copper member can be bonded to each other at a relatively low temperature condition, and deterioration of the ceramic member during bonding can be suppressed.

By the way, recently, depending on the application of the insulating circuit substrate, a thermal cycle that is more severe than in the related art is loaded.

Therefore, there is a demand for an insulating circuit substrate that has a high brazing bonding strength and does not cause cracks in the ceramic substrate even during loading of a thermal cycle, even in an application where a thermal cycle that is more severe than in the related art is loaded.

The present invention has been made in view of the above-described circumstances, and an objective of the present invention is to provide a copper/ceramic bonded body and an insulating circuit substrate, which have a high brazing bonding strength and particularly excellent reliability of a thermal cycle (ceramic substrate is less likely to break).

### Solution to Problem

In order to solve the above-described problem, a copper/ceramic bonded body according to the present invention includes: a copper member made of copper or a copper alloy; and a ceramic member made of silicon-containing ceramics, the copper member and the ceramic member being bonded to each other, in which a maximum indentation hardness in a region is set to be in a range of 70 mgf/µm² or more and 150 mgf/µm² or less, the region being from 10 µm to 50 µm with reference to a bonded interface between the copper member and the ceramic member toward the copper member side.

According to the copper/ceramic bonded body according to the present invention, since the maximum indentation hardness in the region from 10 µm to 50 µm from the bonded interface between the copper member and the ceramic member to the copper member side is set to 70 mgf/µm² or more, the copper in the vicinity of the bonded interface is sufficiently melted, to form a liquid phase, and the ceramic member and the copper member are firmly bonded to each other.

On the other hand, since the maximum indentation hardness in the above-described region is suppressed to 150 mgf/µm² or less, the vicinity of the bonded interface is not harder than necessary, and the generation of cracks during loading of the thermal cycle can be suppressed.

Therefore, it is possible to provide a copper/ceramic bonded body having a high brazing bonding strength and particularly excellent reliability of a thermal cycle.

Here, in the copper/ceramic bonded body according to the present invention, at the bonded interface between the ceramic member and the copper member, an active metal compound layer containing a compound of one or more active metals selected from the group consisting of Ti, Zr, Nb, and Hf is formed on a ceramic member side, and that the maximum particle size of the active metal compound particles in the active metal compound layer is 180 nm or less.

In this case, a proportion of a grain boundary region (metal phase) having a relatively low hardness in the active metal compound layer increases, and the impact resistance of the active metal compound layer is improved. As a result, for example, when a terminal material is ultrasonically bonded to the copper member, it is possible to suppress the generation of cracks in the active metal compound layer, and to suppress peeling of the copper member from the ceramic member and the generation of cracks in the ceramic member.

In the copper/ceramic bonded body according to the present invention, it is preferable that Si, Cu, and Ag are present in the active metal compound layer.

In this case, since Si, Cu, and Ag are present in the active metal compound layer, it is possible to suppress the generation of cracks in the active metal compound layer, and to obtain a copper/ceramic bonded body having a high brazing bonding strength because no unreacted portion is formed at the bonded interface between the copper member and the ceramic member.

An insulating circuit substrate according to the present invention includes: a copper sheet made of copper or a copper alloy; and a ceramic substrate made of silicon-containing ceramics, the copper sheet being bonded to a surface of the ceramic substrate, in which a maximum indentation hardness in a region is set to be in a range of 70 mgf/µm² or more and 150 mgf/µm² or less, the region being from 10 µm to 50 µm with reference to a bonded interface between the copper sheet and the ceramic substrate toward the copper sheet side.

According to the insulating circuit substrate according to the present invention, since the maximum indentation hardness in the region from 10 µm to 50 µm from the bonded interface between the copper sheet and the ceramic substrate to the copper sheet side is set to 70 mgf/µm² or more, the copper in the vicinity of the bonded interface is sufficiently melted, to form a liquid phase, and the ceramic substrate and the copper sheet are firmly bonded to each other.

On the other hand, since the maximum indentation hardness in the above-described region is suppressed to 150 mgf/µm² or less, the vicinity of the bonded interface is not harder than necessary, and the generation of cracks during loading of the thermal cycle can be suppressed.

Therefore, it is possible to provide an insulating circuit substrate having a high brazing bonding strength and particularly excellent reliability of a thermal cycle.

Here, in the insulating circuit substrate according to the present invention, at the bonded interface between the copper sheet and the ceramic substrate, an active metal compound layer containing a compound of one or more active metals selected from the group consisting of Ti, Zr, Nb, and Hf is formed on a ceramic substrate side, and that the maximum particle size of the active metal compound particles in the active metal compound layer is 180 nm or less.

In this case, a proportion of a grain boundary region (metal phase) having a relatively low hardness in the active metal compound layer increases, and impact resistance of the active metal compound layer is improved. As a result, for example, when a terminal material is ultrasonically bonded to the copper sheet, it is possible to suppress the generation of cracks in the active metal compound layer, and to suppress peeling of the copper sheet from the ceramic substrate and the generation of cracks in the ceramic substrate.

In the insulating circuit substrate according to the present invention, it is preferable that Si, Cu, and Ag are present in the active metal compound layer.

In this case, since Si, Cu, and Ag are present in the active metal compound layer, it is possible to suppress the generation of cracks in the active metal compound layer, and to obtain an insulating circuit substrate having a high brazing bonding strength because no unreacted portion is formed at the bonded interface between the copper sheet and the ceramic substrate.

### Advantageous Effects of Invention

According to the present invention, it is possible to provide a copper/ceramic bonded body and an insulating circuit substrate, which have a high brazing bonding strength and particularly excellent reliability of a thermal cycle.

### BRIEF DESCRIPTION OF DRAWINGS

Fig. 1 is a schematic explanatory view of a power module using an insulating circuit substrate according to an embodiment of the present invention.
Fig. 2 is an enlarged explanatory view of a bonded interface between a circuit layer (metal layer) and a ceramic substrate of the insulating circuit substrate according to the embodiment of the present invention.
Fig. 3 is an observation photograph of an active metal compound layer formed at the bonded interface between the circuit layer (metal layer) and the ceramic substrate of the insulating circuit substrate according to the embodiment of the present invention.
Fig. 4 is an example of an EDS spectrum of the active metal compound layer.
Fig. 5 is a flowchart of a production method of the insulating circuit substrate according to the embodiment of the present invention.
Fig. 6 is a schematic explanatory view of the production method of the insulating circuit substrate according to the embodiment of the present invention.
Fig. 7 is an explanatory view showing a measurement point of the maximum indentation hardness in the vicinity of a bonded interface in Examples.
Fig. 8 is an explanatory view showing a measurement principle of an indentation hardness test in Examples.

### DESCRIPTION OF EMBODIMENTS

Hereinafter, an embodiment of the present invention will be described with reference to the accompanying drawings.

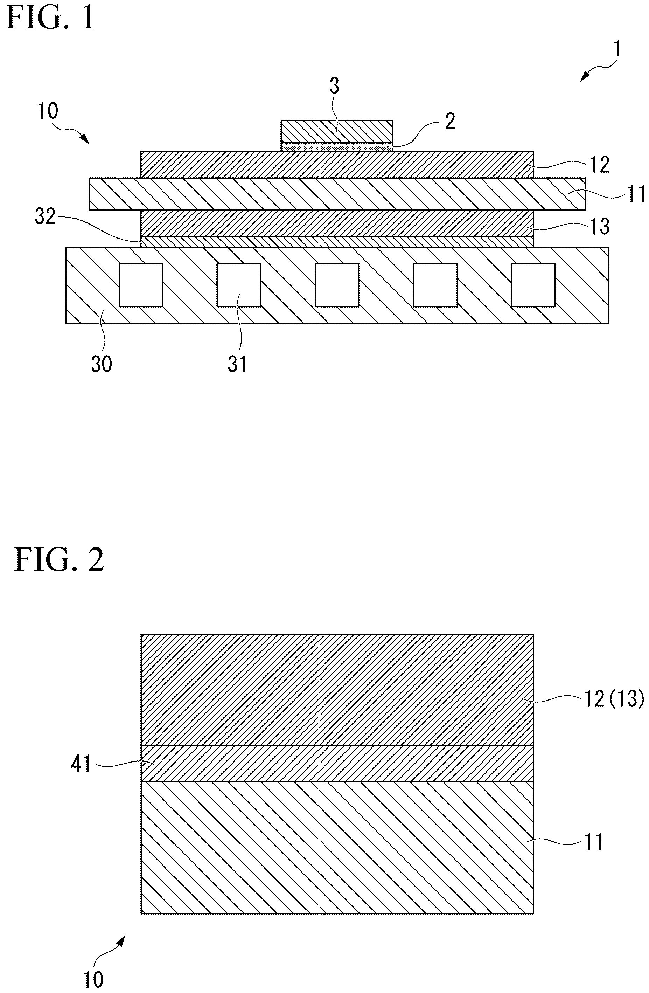

A copper/ceramic bonded body according to the present embodiment is an insulating circuit substrate 10 formed by bonding a ceramic substrate 11 as a ceramic member made of ceramics to a copper sheet 22 (circuit layer 12) and a copper sheet 23 (metal layer 13) as a copper member made of copper or a copper alloy. Fig. 1 shows a power module 1 including the insulating circuit substrate 10 according to the present embodiment.

The power module 1 includes the insulating circuit substrate 10 on which the circuit layer 12 and the metal layer 13 are disposed, a semiconductor element 3 bonded to one surface (upper surface in Fig. 1) of the circuit layer 12 with a bonding layer 2 interposed therebetween, and a heat sink 30 disposed on the other side (lower side in Fig. 1) of the metal layer 13.

The semiconductor element 3 is made of a semiconductor material such as Si. The semiconductor element 3 and the circuit layer 12 are bonded to each other with the bonding layer 2 interposed therebetween.

The bonding layer 2 is made of, for example, a Sn-Ag-based, Sn-In-based, or Sn-Ag-Cu-based solder material.

The heat sink 30 dissipates heat from the above-mentioned insulating circuit substrate 10. The heat sink 30 is made of copper or a copper alloy, and in the present embodiment, the heat sink 30 is made of phosphorus deoxidized copper. The heat sink 30 is provided with a passage 31 through which a cooling fluid flows.

In the present embodiment, the heat sink 30 and the metal layer 13 are bonded to each other by a solder layer 32 made of a solder material. The solder layer 32 is made of, for example, a Sn-Ag-based, Sn-In-based, or Sn-Ag-Cu-based solder material.

As shown in Fig. 1, the insulating circuit substrate 10 according to the present embodiment includes the ceramic substrate 11, the circuit layer 12 disposed on one surface (upper surface in Fig. 1) of the ceramic substrate 11, and the metal layer 13 disposed on the other surface (lower surface in Fig. 1) of the ceramic substrate 11.

The ceramic substrate 11 is made of silicon-containing ceramics having excellent insulating properties and heat radiation, and in the present embodiment, the ceramic substrate 11 is made of silicon nitride (Si₃N₄). The thickness of the ceramic substrate 11 is set to be in a range of, for example, 0.2 mm or more and 1.5 mm or less, and in the present embodiment, the thickness is set to 0.32 mm.

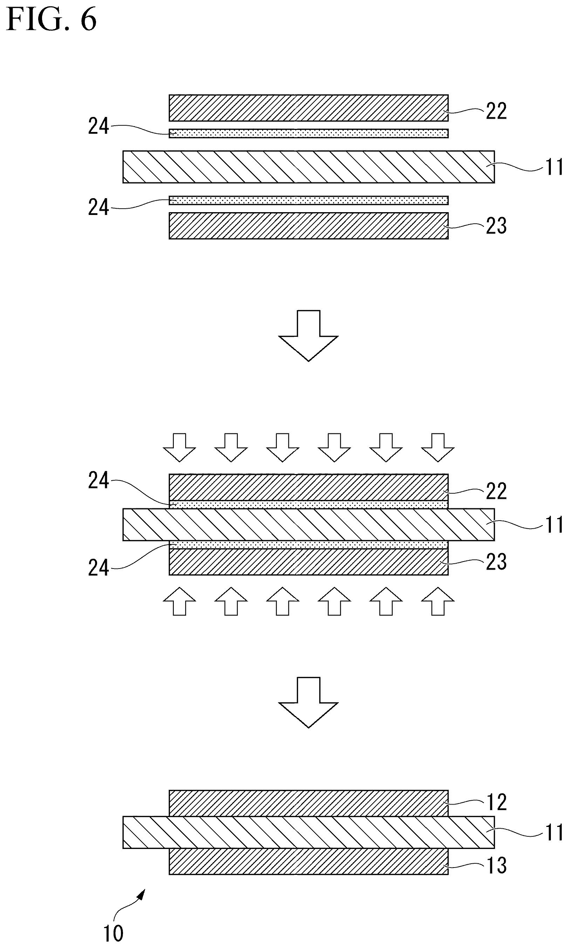

As shown in Fig. 6, the circuit layer 12 is formed by bonding the copper sheet 22 made of copper or a copper alloy to one surface (upper surface in Fig. 6) of the ceramic substrate 11.

In the present embodiment, the circuit layer 12 is formed by bonding the copper sheet 22 made of a rolled plate of oxygen-free copper to the ceramic substrate 11.

The thickness of the copper sheet 22 serving as the circuit layer 12 is set to be in a range of 0.1 mm or more and 2.0 mm or less, and in the present embodiment, the thickness is set to 0.6 mm.

As shown in Fig. 6, the metal layer 13 is formed by bonding the copper sheet 23 made of copper or a copper alloy to the other surface (lower surface in Fig. 6) of the ceramic substrate 11.

In the present embodiment, the metal layer 13 is formed by bonding the copper sheet 23 made of a rolled plate of oxygen-free copper to the ceramic substrate 11.

The thickness of the copper sheet 23 serving as the metal layer 13 is set to be in a range of 0.1 mm or more and 2.0 mm or less, and in the present embodiment, the thickness is set to 0.6 mm.

At the bonded interface between the ceramic substrate 11 and the circuit layer 12 (metal layer 13), as shown in Fig. 2, an active metal compound layer 41 containing a compound of one or more active metals selected from the group consisting of Ti, Zr, Nb, and Hf is formed.

The active metal compound layer 41 is formed by reacting an active metal contained in a bonding material with the ceramic substrate 11.

In the present embodiment, Ti is used as the active metal and the ceramic substrate 11 is made of aluminum nitride, so that the active metal compound layer 41 becomes a titanium nitride (TiN) layer.

In the insulating circuit substrate 10 according to the present embodiment, the maximum indentation hardness in a region from 10 µm to 50 µm from the bonded interface between the circuit layer 12 (metal layer 13) and the ceramic substrate 11 to the circuit layer 12 (metal layer 13) side is in a range of 70 mgf/µm² or more and 150 mgf/µm² or less.

The lower limit of the maximum indentation hardness is preferably 75 mgf/µm² or more, and more preferably 85 mgf/µm² or more. On the other hand, the upper limit of the maximum indentation hardness is preferably 135 mgf/µm² or less, and more preferably 125 mgf/µm² or less.

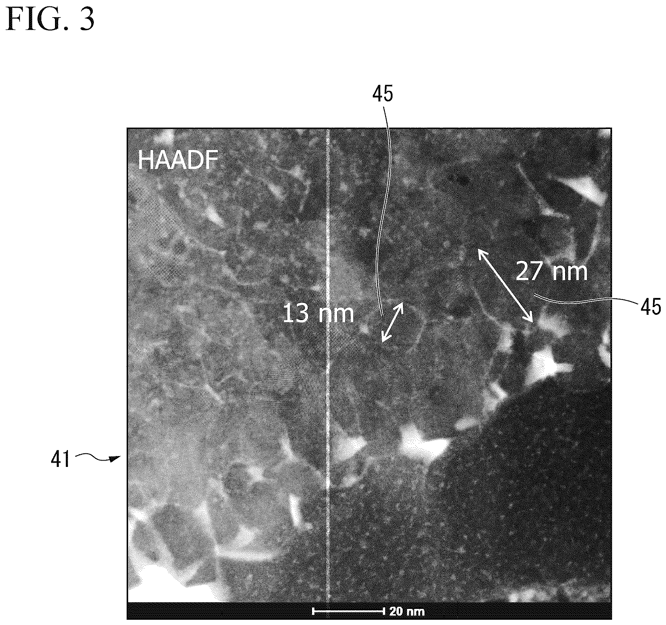

In the insulating circuit substrate 10 according to the present embodiment, as shown in Fig. 3, the maximum particle size of active metal compound particles 45 in the active metal compound layer 41 is 180 nm or less. Grain boundaries between the active metal compound particles 45 form a metal phase. Since the maximum particle size of the active metal compound particles 45 is 180 nm or less, a proportion of a metal phase having a relatively low hardness increases, and impact resistance of the active metal compound layer 41 is improved. As a result, for example, when a terminal material is ultrasonically bonded to the copper member, it is possible to suppress the generation of cracks in the active metal compound layer 41, and to suppress peeling of the copper member from the ceramic member and the generation of cracks in the ceramic member.

The maximum particle size of the active metal compound particles 45 in the active metal compound layer 41 is more preferably 150 nm or less, and still more preferably 120 nm or less.

Further, in the insulating circuit substrate 10 according to the present embodiment, it is preferable that Si, Cu, and Ag are present in the active metal compound layer 41.

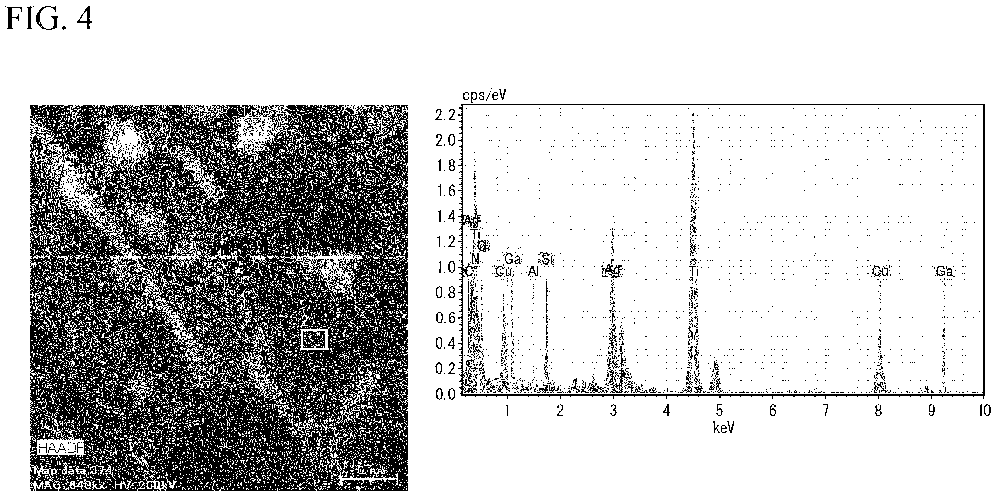

Si, Cu, and Ag present in the active metal compound layer 41 can be confirmed by observing the interparticles and the grain boundaries of the active metal compound particles 45 in the active metal compound layer 41 using a transmission electron microscope and obtaining an EDS spectrum. An example of the EDS spectrum of the active metal compound layer 41 is shown in Fig. 4. Peaks of Si, Cu, and Ag are confirmed, and it can be seen that Si, Cu, and Ag are present in the active metal compound layer 41.

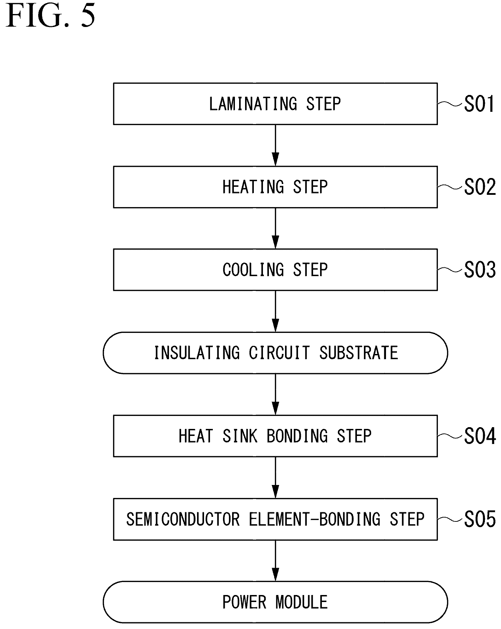

Hereinafter, a production method of the insulating circuit substrate 10 according to the present embodiment will be described with reference to Figs. 5 and 6.

### (Laminating Step S01)

First, the ceramic substrate 11 made of silicon nitride (Si₃N₄) is prepared, and as shown in Fig. 6, an Ag-Ti-based brazing material (Ag-Cu-Ti-based brazing material) 24 is disposed between the copper sheet 22 serving as the circuit layer 12 and the ceramic substrate 11, and between the copper sheet 23 serving as the metal layer 13 and the ceramic substrate 11.

As the Ag-Ti-based brazing material (Ag-Cu-Ti-based brazing material) 24, for example, it is preferable to use a composition containing Cu in a range of 0 mass% or more and 32 mass% or less, Ti as an active metal in a range of 0.5 mass% or more and 20 mass% or less, and a balance being Ag and inevitable impurities. The thickness of the Ag-Cu-Ti-based brazing material 24 is preferably in a range of 2 µm or more and 10 µm or less.

### (Heating Step S02)

Next, the copper sheet 22 and the ceramic substrate 11 are heated in a heating furnace in a vacuum atmosphere in a state of being pressed, to melt the Ag-Ti-based brazing material (Ag-Cu-Ti-based brazing material) 24.

Here, a heating temperature in the heating step S02 is in a range of the eutectic point temperature of Cu and Si or more and 850°C or less. In the heating step S02, a temperature integration value at the above-described heating temperature is in a range of 1 °C·h or higher and 110 °C·h or lower.

A pressing load in the heating step S02 is in a range of 0.029 MPa or more and 2.94 MPa or less.

### (Cooling Step S03)

Then, after the heating step S02, the molten Ag-Ti-based brazing material (Ag-Cu-Ti-based brazing material) 24 is solidified by cooling.

A cooling rate in the cooling step S03 is preferably in a range of 2 °C/min or higher and 10 °C/min or lower.

Here, in the heating step S02, a eutectic liquid phase is present at the grain boundary of TiN in the active metal compound layer 41, and Si on the ceramic substrate 11 side and Ag, Cu, and Ti of the Ag-Cu-Ti-based brazing material 24 diffuse into each other by using the eutectic liquid phase as a diffusion path, thereby promoting the interfacial reaction of the ceramic substrate 11.

As a result, the maximum indentation hardness in a region from 10 µm to 50 µm from the bonded interface with the ceramic substrate 11 to the circuit layer 12 (metal layer 13) side is in a range of 70 mgf/µm² or more and 150 mgf/µm² or less.

As described above, the ceramic substrate 11 and the copper sheets 22 and 23 are bonded to each other by the laminating step S01, the heating step S02, and the cooling step S03, thereby producing the insulating circuit substrate 10 according to the present embodiment.

### (Heat Sink Bonding Step S04)

Next, the heat sink 30 is bonded to the other surface side of the metal layer 13 of the insulating circuit substrate 10.

The insulating circuit substrate 10 and the heat sink 30 are laminated with a solder material interposed therebetween and are loaded into a heating furnace such that the insulating circuit substrate 10 and the heat sink 30 are solder-bonded to each other with the solder layer 32 interposed therebetween.

### (Semiconductor Element-Bonding Step S05)

Next, the semiconductor element 3 is bonded to one surface of the circuit layer 12 of the insulating circuit substrate 10 by soldering.

The power module 1 shown in Fig. 1 is produced by the above steps.

According to the insulating circuit substrate 10 (copper/ceramic bonded body) according to the present embodiment having the above configuration, since the maximum indentation hardness in the region from 10 µm to 50 µm from the bonded interface between the circuit layer 12 (metal layer 13) and the ceramic substrate 11 to the circuit layer 12 (metal layer 13) is set to 70 mgf/µm² or more, the copper in the vicinity of the bonded interface is sufficiently melted to form a liquid phase, and the ceramic substrate 11 and the circuit layer 12 (metal layer 13) are more firmly bonded to each other.

On the other hand, since the maximum indentation hardness is suppressed to 150 mgf/µm² or less, the vicinity of the bonded interface is not harder than necessary, and the generation of cracks during loading of the thermal cycle can be suppressed.

In the insulating circuit substrate 10 according to the present embodiment, in a case where the maximum particle size of the active metal compound particles 45 in the active metal compound layer 41 formed at the bonded interface between the ceramic substrate 11 and the circuit layer 12 (metal layer 13) is 180 nm or less, a proportion of a grain boundary region formed of a metal phase having a relatively low hardness in the active metal compound layer 41 increases, and impact resistance of the active metal compound layer 41 can be secured. As a result, for example, when a terminal material is ultrasonically bonded to the circuit layer 12 (metal layer 13), it is possible to suppress the generation of cracks in the active metal compound layer 41, and to suppress peeling of the circuit layer 12 (metal layer 13) from the ceramic substrate 11 and the generation of cracks in the ceramic substrate 11.

In the insulating circuit substrate 10 according to the present embodiment, in a case where Si, Cu, and Ag are present in the active metal compound layer 41, it is possible to suppress the generation of cracks in the active metal compound layer 41, and to obtain an insulating circuit substrate 10 having a high brazing bonding strength because no unreacted portion is formed at the bonded interface between the ceramic substrate 11 and the circuit layer 12 (metal layer 13).

The embodiment of the present invention has been described, but the present invention is not limited thereto, and can be appropriately changed without departing from the scope of the present invention as defined in the appended claims 1-4.

For example, in the present embodiment, the semiconductor element is mounted on the insulating circuit substrate to form the power module, but the present embodiment is not limited thereto. For example, an LED element may be mounted on the circuit layer of the insulating circuit substrate to form an LED module, or a thermoelectric element may be mounted on the circuit layer of the insulating circuit substrate to form a thermoelectric module.

In the insulating circuit substrate according to the present embodiment, it has been described that the circuit layer and the metal layer are both made of a copper sheet made of copper or a copper alloy, but the present invention is not limited thereto.

For example, in a case where the circuit layer and the ceramic substrate are made of the copper/ceramic bonded body according to the present invention, there is no limitation on the material and the bonding method of the metal layer. There may be no metal layer, the metal layer may be made of aluminum or an aluminum alloy, or may be made of a laminate of copper and aluminum.

On the other hand, in a case where the metal layer and the ceramic substrate are made of the copper/ceramic bonded body according to the present invention, there is no limitation on the material and the bonding method of the circuit layer. The circuit layer may be made of aluminum or an aluminum alloy, or may be made of a laminate of copper and aluminum.

In the present embodiment, it has been described that the Ag-Ti-based brazing material (Ag-Cu-Ti-based brazing material) 24 is disposed between the copper sheets 22 and 23 and the ceramic substrate 11 in the laminating step S01, but the present invention is not limited thereto, and a bonding material containing another active metal may be used.

In the present embodiment, it has been described that the ceramic substrate is made of silicon nitride (Si₃N₄), but the present invention is not limited thereto, and the ceramic substrate may be made of other silicon-containing ceramics.

### EXAMPLES

Hereinafter, results of confirmation experiments performed to confirm the effects of the present invention will be described.

### (Example 1)

First, a ceramic substrate (40 mm × 40 mm × 0.32 mm) made of silicon nitride (Si₃N₄) was prepared.

A copper sheet (37 mm × 37 mm × thickness of 1.0 mm) made of oxygen-free copper was bonded to both surfaces of the ceramic substrate under the conditions shown in Table 1 by using an Ag-Cu-based brazing material containing an active metal shown in Table 1, to obtain an insulating circuit substrate (copper/ceramic bonded body). The degree of vacuum of a vacuum furnace at the time of bonding was set to 5 × 10⁻³ Pa.

For the obtained insulating circuit substrate (copper/ceramic bonded body), the maximum indentation hardness in the vicinity of a bonded interface, and the reliability of the thermal cycle were evaluated as follows.

### (Maximum Indentation Hardness in Vicinity of Bonded Interface)

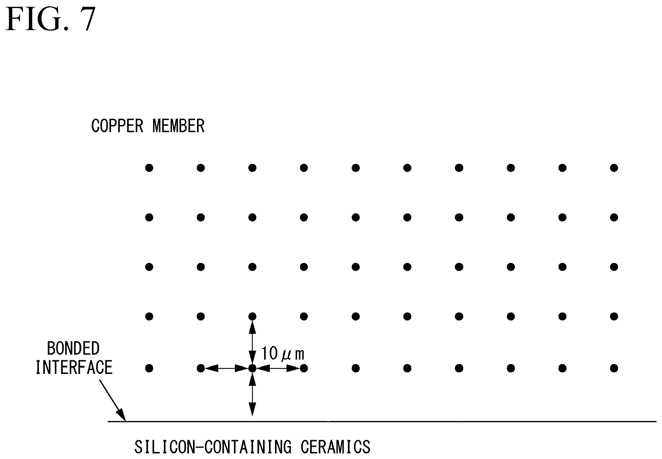

The maximum indentation hardness was measured in a region from 10 µm to 50 µm from the bonded interface between the copper sheet and the ceramic substrate to the copper sheet side by using an indentation hardness tester (ENT-1100a manufactured by Elionix Inc.). The measurement condition was Fₘₐₓ = 5000 mgf (number of divisions = 500, step interval = 20 ms) using a Berkovich indenter. A target section was exposed by buffing to make a measuring surface, and as shown in Fig. 7, the indentation hardness was measured at 50 measurement points at intervals of 10 µm, and the maximum value of the indentation hardness among them was confirmed.

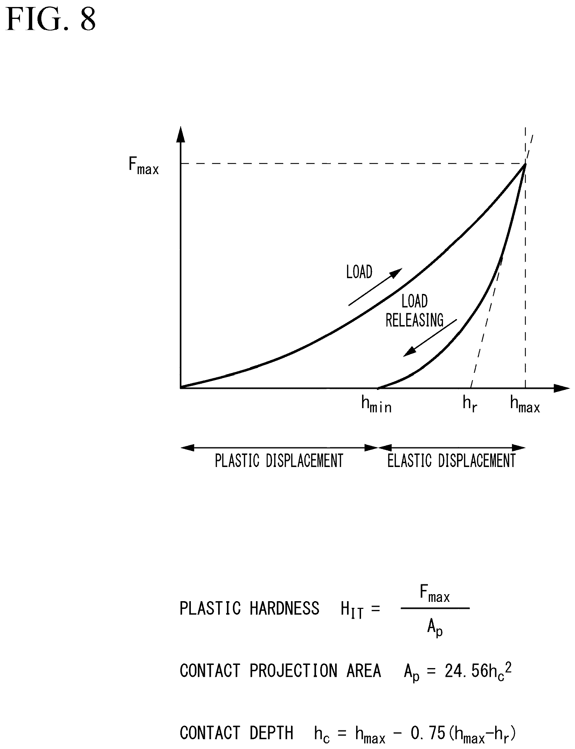

In this indentation hardness test, as shown in Fig. 8, a load applied in the indenter indentation process and an indentation depth can be continuously measured, and information such as plasticity/elasticity/creep can be obtained from a load-displacement curve.

### (Reliability of Thermal Cycle)

After holding in the following atmosphere, the bonded interface between the copper sheet and the ceramic substrate was inspected by SAT inspection, and the presence or absence of ceramic breaking was determined.
-78°C × 2 minutes ← → 350°C × 2 minutes

The number of cycles in which breaking occurred was evaluated. A case where breaking was confirmed in less than 6 times of cycle was evaluated as "C", and a case where breaking was not confirmed even in 6 times or more of cycle was evaluated as "A". The evaluation results are shown in Table 1.

**[Table 1]**

| | Active metal | Heating step | | Maximum indentation hardness at bonded interface 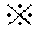 (kgf/µm²) | Reliability of thermal cycle |
|---|---|---|---|---|---|
| | | Load (MPa) | Temperature integration value (°C·h) | | |
| Present Invention Example 1 | Ti | 2.94 | 100 | 70 | A |
| Present Invention Example 2 | Ti | 0.098 | 1 | 150 | A |
| Present Invention Example 3 | Ti | 1.96 | 78 | 100 | A |
| Present Invention Example 4 | Hf | 1.47 | 22 | 134 | A |
| Present Invention Example 5 | Zr | 0.49 | 88 | 91 | A |
| Present Invention Example 6 | Zr | 0.49 | 56 | 124 | A |
| Present Invention Example 7 | Nb | 0.049 | 8 | 144 | A |
| Present Invention Example 8 | Zr | 0.98 | 70 | 101 | A |
| Comparative Example 1 | Ti | 0.098 | 0.5 | 173 | C |
| Comparative Example 2 | Zr | 0.49 | 0.7 | 160 | C |

| | | | | | |
|---|---|---|---|---|---|
| 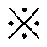 Maximum indentation hardness in region from 10 µm to 50 µm from bonded interface between copper sheet and ceramic substrate to copper sheet side | | | | | |

In Comparative Example 1 in which a temperature integration value in the heating step was 0.5 °C·h using Ti as the active metal, the maximum indentation hardness of the bonded interface was 174 mgf/µm², which was larger than the range of the present invention, and the reliability of the thermal cycle was "C".

In Comparative Example 2 in which a temperature integration value in the heating step was 0.7 °C·h using Zr as the active metal, the maximum indentation hardness of the bonded interface was 160 mgf/µm², which was larger than the range of the present invention, and the reliability of the thermal cycle was "C".

On the other hand, in Present Invention Examples 1 to 8 in which the maximum indentation hardness of the bonded interface was in a range of 70 mgf/µm² or more and 150 mgf/µm² or less, the reliability of the thermal cycle was "A" regardless of the type of the active metal.

### (Example 2)

A ceramic substrate (40 mm × 40 mm × 0.32 mm) made of silicon nitride (Si₃N₄) was prepared.

A copper sheet (37 mm × 37 mm × thickness of 0.2 mm) made of oxygen-free copper was bonded to both surfaces of the ceramic substrate under the conditions shown in Table 2 by using an Ag-Cu-based brazing material containing an active metal shown in Table 2, to obtain an insulating circuit substrate (copper/ceramic bonded body). A degree of vacuum of a vacuum furnace at the time of bonding was set to 5 × 10⁻³ Pa.

For the obtained insulating circuit substrate (copper/ceramic bonded body), the maximum indentation hardness in the vicinity of a bonded interface was evaluated by the same method as in Example 1.

In addition, the maximum particle size of the active metal compound particles in the active metal compound layer, the presence or absence of Si, Ag, and Cu in the active metal compound layer, and ultrasonic welding were evaluated by the method shown below.

### (Maximum Particle Size of Active Metal Compound Particles)

The active metal compound layer was observed at a magnification of 500,000x by using a transmission electron microscope (Titan ChemiSTEM manufactured by FEI Company), to obtain a HAADF image.

By image analysis of the HAADF image, the equivalent circle diameter of the active metal compound particles was calculated. From the results of image analysis in 10 fields of view, the maximum equivalent circle diameter of the observed active metal compound particles is shown in Table 2 as the maximum particle size.

### (Presence or Absence of Si, Ag, and Cu in Active Metal Compound Layer)

The grain boundaries in the active metal compound layer were integrated for 1100 frames at an acceleration voltage of 200 kV, a magnification of 500,000x to 700,000x, and 7 µs per point by using a transmission electron microscope (Titan ChemiSTEM manufactured by FEI Company). In the EDS spectrum, in a case where Si, Ag, and Cu were 0.15 cps/eV, Si, Ag, and Cu were evaluated as "present".

### (Evaluation of Ultrasonic Welding)

A copper terminal (10 mm × 20 mm × 2.0 mm in thickness) was ultrasonically bonded to the insulating circuit substrate by using an ultrasonic metal bonding machine (60C-904 manufactured by Ultrasonic Engineering Co., Ltd.) under the conditions of a load of 850 N, a collapse amount of 0.7 mm, and a bonding area of 5 mm × 5 mm. Fifty copper terminals were bonded at a time.

After bonding, the bonded interface between the copper sheet and the ceramic substrate was inspected by using an ultrasonic flaw detector (FineSAT200 manufactured by Hitachi Solutions, Ltd.). A case where peeling of the copper sheet from the ceramic substrate or ceramic breaking was observed in 5 pieces or more out of 50 pieces was evaluated as "D", a case where peeling of the copper sheet from the ceramic substrate or ceramic breaking was observed in 3 pieces or more and 4 pieces or less out of 50 pieces was evaluated as "C", a case where peeling of the copper sheet from the ceramic substrate or ceramic breaking was observed in 1 piece or more and 2 pieces or less out of 50 pieces was evaluated as "B", and a case where peeling of the copper sheet from the ceramic substrate or ceramic breaking was not observed in all 50 pieces was evaluated as "A". The evaluation results are shown in Table 2.

**[Table 2]**

| | Active metal | Heating step | | | Active metal compound layer | | | Maximum indentation hardness at bonded interface 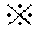 (kgf/µm²) | Evaluation of ultrasonic welding |
|---|---|---|---|---|---|---|---|---|---|
| | | Load (MPa) | Temperature integration value (°C·h) | Heating temperature (°C) | Material | Si, Ag, and Cu | Maximum particle size (µm) | | |
| Present Invention Example 11 | Ti | 0.098 | 1 | 825 | TiN | Present | 89 | 150 | A |
| Present Invention Example 12 | Ti | 0.098 | 10 | 825 | TiN | Present | 102 | 136 | A |
| Present Invention Example 13 | Ti | 0.098 | 26 | 835 | TiN | Present | 131 | 123 | B |
| Present Invention Example 14 | Hf | 1.47 | 22 | 825 | HfN | Present | 118 | 134 | A |
| Present Invention Example 15 | Hf | 1.47 | 37 | 835 | HfN | Present | 150 | 121 | B |
| Present Invention Example 16 | Hf | 1.47 | 60 | 815 | HfN | Present | 115 | 116 | A |
| Present Invention Example 17 | Zr | 0.49 | 56 | 835 | ZrN | Present | 156 | 124 | C |
| Present Invention Example 18 | Zr | 0.49 | 72 | 835 | ZrN | Present | 179 | 110 | C |
| Comparative Example 19 | Zr | 0.49 | 110 | 850 | ZrN | Present | 213 | 91 | D |

| | | | | | | | | | |
|---|---|---|---|---|---|---|---|---|---|
| 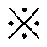 Maximum indentation hardness in region from 10 µm to 50 µm from bonded interface between copper sheet and ceramic substrate to copper sheet side | | | | | | | | | |

From the comparison among Present Invention Examples 11 to 13 in which the active metal is Ti, among Present Invention Examples 14 to 16 in which the active metal is Hf, and among Present Invention Examples 17 and 18 in which the active metal is Zr, it is confirmed that the maximum particle size of the active metal compound particles in the active metal compound layer is reduced, whereby the peeling of the copper sheet from the ceramic substrate and the generation of cracks in the ceramic substrate during ultrasonic welding can be suppressed.

As described above, according to Present Invention Examples, it was confirmed that it is possible to provide a copper/ceramic bonded body and an insulating circuit substrate, which have a high brazing bonding strength and a particularly reliable thermal cycle.

### [Reference Signs List]

10: Insulating circuit substrate (copper/ceramic bonded body)
11: Ceramic substrate (ceramic member)
12: Circuit layer (copper member)
13: Metal layer (copper member)
41: Active metal compound layer
45: Active metal compound particles

## Claims

1. A copper/ceramic bonded body comprising:
a copper member made of copper or a copper alloy; and
a ceramic member made of silicon-containing ceramics, the copper member and the ceramic member being bonded to each other,
wherein a maximum indentation hardness in a region is set to be in a range of 70 mgf/µm² or more and 150 mgf/µm² or less, the region being from 10 µm to 50 µm with reference to a bonded interface between the copper member and the ceramic member toward the copper member side, the maximum indentation hardness being the maximum value of the indentation hardness measured by using a Berkovich indenter, as described in the description,
at the bonded interface between the ceramic member and the copper member, an active metal compound layer containing a compound of one or more active metals selected from the group consisting of Ti, Zr, Nb, and Hf is formed on the ceramic member side, and
a maximum particle size of particles of the active metal compound in the active metal compound layer is 180 nm or less, the maximum particle size being the maximum equivalent circle diameter of the active metal compound particles determined by image analysis of the HAADF image observed with a transmission electron microscope, as described in the description.

2. The copper/ceramic bonded body according to Claim 1,
wherein Si, Cu, and Ag are present in the active metal compound layer.

3. An insulating circuit substrate comprising:
a copper sheet made of copper or a copper alloy; and
a ceramic substrate made of silicon-containing ceramics, the copper sheet being bonded to a surface of the ceramic substrate,
wherein a maximum indentation hardness in a region is set to be in a range of 70 mgf/µm² or more and 150 mgf/µm² or less, the region being from 10 µm to 50 µm with reference to a bonded interface between the copper sheet and the ceramic substrate toward the copper sheet side, the maximum indentation hardness being the maximum value of the indentation hardness measured by using a Berkovich indenter, as described in the description,
at the bonded interface between the ceramic member and the copper member, an active metal compound layer containing a compound of one or more active metals selected from the group consisting of Ti, Zr, Nb, and Hf is formed on the ceramic member side, and
a maximum particle size of particles of the active metal compound in the active metal compound layer is 180 nm or less, the maximum particle size being the maximum equivalent circle diameter of the active metal compound particles determined by image analysis of the HAADF image observed with a transmission electron microscope, as described in the description.

4. The insulating circuit substrate according to Claim 3,
wherein Si, Cu, and Ag are present in the active metal compound layer.

## Patentansprüche

1. Gebundener Kupfer/Keramik-Körper, umfassend:
ein Kupferelement aus Kupfer oder einer Kupferlegierung und
ein Keramikelement aus siliciumhaltiger Keramik, wobei das Kupferelement und das Keramikelement miteinander verbunden sind,
wobei eine maximale Eindruckhärte in einen Bereich von 70 mgf/µm² oder mehr und 150 mgf/µm² oder weniger festgelegt ist, wobei der Bereich 10 µm bis 50 µm in Bezug auf eine Bindungsgrenzfläche zwischen dem Kupferelement und dem Keramikelement in Richtung der Kupferelementseite liegt, wobei die maximale Eindruckhärte der maximale Wert der Eindruckhärte ist, der unter Verwendung eines Berkovich-Indenters wie in der Beschreibung beschrieben gemessen wird,
an der Bindungsgrenzfläche zwischen dem Keramikelement und dem Kupferelement eine Aktivmetallverbindungsschicht, die eine Verbindung aus einem oder mehreren Aktivmetallen, ausgewählt aus der Gruppe, bestehend aus Ti, Zr, Nb und Hf, enthält, auf der Keramikelementseite gebildet ist und
eine maximale Partikelgröße von Partikeln der Aktivmetallverbindung in der Aktivmetallverbindungsschicht 180 nm oder weniger beträgt, wobei die maximale Partikelgröße der maximale äquivalente Kreisdurchmesser der Aktivmetallverbindungspartikel ist, der durch Bildanalyse des mit einem Transmissionselektronenmikroskop betrachteten HAADF-Bilds wie in der Beschreibung beschrieben bestimmt wird.

2. Gebundener Kupfer/Keramik-Körper gemäß Anspruch 1,
wobei Si, Cu und Ag in der Aktivmetallverbindungsschicht vorhanden sind.

3. Isolierendes Schaltungssubstrat, umfassend:
ein Kupferblech aus Kupfer oder einer Kupferlegierung und
ein Keramiksubstrat aus siliciumhaltiger Keramik, wobei das Kupferblech mit einer Oberfläche des Keramiksubstrats verbunden ist,
wobei eine maximale Eindruckhärte in einen Bereich von 70 mgf/µm² oder mehr und 150 mgf/µm² oder weniger festgelegt ist, wobei der Bereich 10 µm bis 50 µm in Bezug auf eine Bindungsgrenzfläche zwischen dem Kupferblech und dem Keramiksubstrat in Richtung der Kupferblechseite liegt, wobei die maximale Eindruckhärte der maximale Wert der Eindruckhärte ist, der unter Verwendung eines Berkovich-Indenters wie in der Beschreibung beschrieben gemessen wird,
an der Bindungsgrenzfläche zwischen dem Keramikelement und dem Kupferelement eine Aktivmetallverbindungsschicht, die eine Verbindung aus einem oder mehreren Aktivmetallen, ausgewählt aus der Gruppe, bestehend aus Ti, Zr, Nb und Hf, enthält, auf der Keramikelementseite gebildet ist und
eine maximale Partikelgröße von Partikeln der Aktivmetallverbindung in der Aktivmetallverbindungsschicht 180 nm oder weniger beträgt, wobei die maximale Partikelgröße der maximale äquivalente Kreisdurchmesser der Aktivmetallverbindungspartikel ist, der durch Bildanalyse des mit einem Transmissionselektronenmikroskop betrachteten HAADF-Bilds wie in der Beschreibung beschrieben bestimmt wird.

4. Isolierendes Schaltungssubstrat gemäß Anspruch 3,
wobei Si, Cu und Ag in der Aktivmetallverbindungsschicht vorhanden sind.

## Revendications

1. Corps lié de cuivre/céramique comprenant :
un élément en cuivre réalisé en cuivre ou en alliage de cuivre ; et
un élément en céramique réalisé en céramique contenant du silicium, l'élément en cuivre et l'élément en céramique étant liés l'un à l'autre,
dans lequel une dureté d'indentation maximale dans une zone est fixée pour être dans une plage de 70 mgf/µm² ou plus et de 150 mgf/µm² ou moins, la zone étant de 10 µm à 50 µm en référence à une interface liée entre l'élément en cuivre et l'élément en céramique vers le côté de l'élément en cuivre, la dureté d'indentation maximale étant la valeur maximale de la dureté d'indentation mesurée à l'aide d'un indenteur Berkovich, comme décrit dans la description,
au niveau de l'interface liée entre l'élément en céramique et l'élément en cuivre, une couche de composé métallique actif contenant un composé d'un ou plusieurs métaux actifs sélectionnés à partir du groupe constitué de Ti, Zr, Nb et Hf est formée sur le côté de l'élément en céramique, et
une taille de particule maximale de particules du composé métallique actif dans la couche de composé métallique actif est de 180 nm ou moins, la taille de particule maximale étant le diamètre de cercle équivalent maximal des particules de composé métallique actif déterminé par analyse d'image de l'image HAADF observée avec un microscope électronique à transmission, comme décrit dans la description.

2. Corps lié de cuivre/céramique selon la revendication 1,
dans lequel Si, Cu et Ag sont présents dans la couche de composé métallique actif.

3. Substrat de circuit d'isolation comprenant :
une feuille de cuivre réalisée en cuivre ou en alliage de cuivre ; et
un substrat en céramique réalisé en céramique contenant du silicium, la feuille de cuivre étant liée à une surface du substrat en céramique,
dans lequel une dureté d'indentation maximale dans une zone est fixée pour être dans une plage de 70 mgf/µm² ou plus et de 150 mgf/µm² ou moins, la zone étant de 10 µm à 50 µm en référence à une interface liée entre la feuille de cuivre et le substrat en céramique vers le côté de la feuille de cuivre, la duretée par indentation maximale étant la valeur maximale de la dureté d'indentation mesurée à l'aide d'un indenteur Berkovich, comme décrit dans la description,
au niveau de l'interface liée entre l'élément en céramique et l'élément en cuivre, une couche de composé métallique actif contenant un composé d'un ou plusieurs métaux actifs sélectionnés à partir du groupe constitué de Ti, Zr, Nb et Hf est formée sur le côté de l'élément en céramique, et
une taille de particule maximale de particules du composé métallique actif dans la couche de composé métallique actif est de 180 nm ou moins, la taille de particule maximale étant le diamètre de cercle équivalent maximal des particules de composé métallique actif déterminé par analyse d'image de l'image HAADF observée avec un microscope électronique à transmission, comme décrit dans la description.

4. Substrat de circuit d'isolation selon la revendication 3,
dans lequel Si, Cu et Ag sont présents dans la couche de composé métallique actif.
